# EUROPEAN PATENT APPLICATION

(11) **EP 3 163 435 A1**
(43) Date of publication of application: **03.05.2017**
(21) Application number: 15811524.6
(22) Date of filing: 25.06.2015
(51) Int. Cl.: G06F 9/44

(54) **METHOD FOR GENERAL MODELING BASING ON SYSTEM META MODEL TO CONSTRUCT SYSTEM MODEL**

(30) Priority: 25.06.2014 CN 201410292935
(71) Applicant: Chengdu Puzhong Software Limited Company, Chengdu, Sichuan 610041 (CN)
(72) Inventor: FU, Changming, Chengdu Sichuan 610057 (CN)
(74) Representative: Gallego Jiménez, José Fernando
(86) International application number: PCT/CN2015/000451
(87) International publication number: WO 2015/196780

(57) **Abstract**

A method for general modeling basing on system meta model to construct system model. After determining basic components of the system meta model, the present invention constructs system models through the hierarchy model, the interface model, the algorithm model, the process model, and the transfer model as step features and thereby provides a specification for system modeling in various fields; such specification has advantages including generality and convenience; system models constructed through the present invention is executable, has a clear structure, adjustable hierarchies, and controllable granularities for modeling; this method supports both top-down analysis and bottom-up integration for modeling in various systems including software systems and information systems. The quantity of required elements for modeling is small and the modeling method is simple, thereby even those not skilled in any modeling language nor computer programming language can easily and independently construct system model, eliminating the tedious and unnecessary communication with and dependence on professional modelers and application developers, greatly reducing modeling time.

## Description

### TECHNICAL FIELD

The present invention relates to the technical field of software engineering, and more specifically, it is a method for general modeling basing on system meta model to construct system model and a computer program product thereof.

### TECHNICAL BACKGROUND

A system is a joint name for objects and events in the real or imaginary world, and a system model refers to a structured description of knowledge about the objects, especially complex objects. System modeling is an action or a process in which a system model is constructed based on laws and features of the objects. Long before the emergence of software, system modeling already exists widely in various practical social activities such as scientific research, engineering, military, and industries. Nowadays, with rapidly developing information technology, especially software technology, system modeling has become a basic activity that is profoundly affecting social development. The quality and efficiency of system modeling has become a key factor in determining whether information technology can be used to gain industry advantage and development.

When specific systems are modeled, users found that these system models share many common constructions where these constructions can be described by a model called system meta model. The system meta model is a model describing system models; it is an abstraction of the system models and provides a precise definition of a perfect set of components and rules required for creating rigorous system models. The system meta model is used as a specification for system modeling and plays a decisive role in the quality and efficiency of system modeling.

Precisely because of the important role system meta model plays in system modeling, study of system meta modeling has been a major focus. Typical examples of these system meta models are state machine, petri net etc. However, these system meta models usually target problems of specific types rather than providing a universal description for general system modeling. The UML (Unified Modeling Language) is the current mainstream industry standard for object oriented visual modeling language. In fact, even though UML is a software meta model developed from object oriented software methods, it is used as a system meta-model to a large extent. For system modeling, the UML has the following drawbacks: Firstly, UML cannot provide modeling methods: UML clearly states that it does not provide modeling methods and is only a descriptive language for modeling methods; UML is oriented towards programmers, targeting the development of modeling products in the software development process. In reality, it focuses on the description of implementation model in object-oriented programming, not a general system modeling method beyond software development. Secondly, the lack of executability thereof is a fatal drawback: the UML lacks a rigorous theoretical support for modeling, which has been criticized by insiders; the deficiency of completeness and consistency results in a system model constructed by the UML being lack of executability, i.e., the model described by using UML cannot be automatically converted into a software executable by computers. The yielded software must be manually edited through codes in order to be executable by computers. This drawback makes the UML only be a supplementary expression tool for system modeling rather than a true system meta model. Thirdly, it is difficult to understand and use: the UML creates a lot of concepts, relations and diagrams. Relationships among these concepts, relations, and diagrams are loose and numerous. The UML is originally designed for programmers. However, the UML's complication and disorder are not only hard for programmers to grasp, but also even more difficult for industry experts to understand, far from satisfying the needs of modeling. The above comments can also be applied to sysML, a visual modeling language derived from the UML and oriented towards engineering.

With a gradual rise of knowledge engineering, ontology meta model recently is becoming a hot topic of research. Ontology is defined as an explicit specification of a conceptual model. The ontology meta model effectively determines concepts commonly recognized in an industry with concepts as core elements, formal language as means of description, and formal logic as reasoning mechanisms, and gives clear definitions of the relations among these concepts. The ontology meta model focuses on establishment and application of concept system and on classification, expression, and reasoning of information. The modeling primitive for the theory of the ontology meta models includes concepts, relations, functions, axioms, and instances, providing a theoretical framework from the view of knowledge management: the international standard ISO /IEC19763 (interoperable meta model framework MFI) provides a management specification with concept ontology and process ontology as core knowledge and information sharing specification with an ontology registration meta model and a process registration meta model as cores; Chinese patent filing 200610125050.8 provides an application method for WEB service oriented industry requirement modeling based on ISO/IEC 19763's ontology registration meta-model, process registration meta-model and ontology description tool Protege. From the system modeling perspective, first, the ontology meta model focuses on knowledge management and information sharing rather than universal system modeling; second, ontology meta model employs formal language, which is difficult for personnel.

In all, a system meta-model that is easy for ordinary industry personnel to grasp, provides a universal system modeling norm, supports system modeling in all fields, and constructs executable models, currently is still lacking and in demand.

### SUMMARY OF THE INVENTION

In view of the above drawbacks of the prior art, the objective of the present invention is to provide a method for general modeling basing on system meta model to construct system models in order to overcome the above drawbacks of the prior art.

The objective of the present invention is achieved by the following means.

Method for general modeling basing on system meta-model to construct system models, comprising a computer readable storage medium having a computer readable program code stored therein, said computer readable program code containing instructions executable by a processor of a computer system to implement a method of constructing system model by processing data conforming to the system meta-model, said system meta-model comprising:
a hierarchy mold which describes the hierarchy model of the system model in a tree structure of which a node is a component class and which is used as a template to be configured in an actual system modeling environment to form the hierarchy model of the system model, wherein the hierarchy model refers to the hierarchy relationships constituted by the component classes as the nodes in the system model, wherein the component class refers to a set of component instances with the same external features, and wherein the tree structure, of which the nodes are component classes, in the system model is referred as a hierarchy tree;
an interface mold which describes interface models by an optional structure of an attribute set, a function set, and an event set. The interface mold is used as a template in the actual system modeling environment to be configured to form interface models, wherein interface models refers to external features of component classes, wherein the functions in the function set include both algorithm functions and process functions, wherein an algorithm function is implemented by an algorithm model, and wherein a process functions is implemented by a combination of a process model and transfer models;
an algorithm mold which describes algorithm models by a tree structure of which nodes are operators and which is used as a template in actual system modeling environment to be configured to form the algorithm model, wherein the algorithm model refers to a description of the algorithm which implements a function by using the combination of operators, and wherein operator refers to component with a previously realized specific function;
a process mold which describes process models by combining actions as nodes, and as a template, to configure process models in the actual system modeling environment, wherein the process model refers to a description of a way of a function which is implemented using a combination of the actions and wherein the action refers to an execution of a function;
a transfer mold which describes transfer models by a transfer set and which is used as a template in actual system configuration modeling environment to be configured to form transfer models, wherein transfer model refers to transfer relationships of the data of involved actions and a transfer in the transfer set is transfer relationship of the data between one attribute and another attribute;
specific steps to construct the system model described by the said five molds being as follows:
   1) constructing the hierarchy model: the hierarchy mold reads in hierarchy model commands from the actual system modeling environment, wherein hierarchy model commands refers to commands such as creating a component class, adding a component class, selecting a component class, naming a component class, and deleting a component class for the hierarchy tree and wherein the hierarchy mold performs corresponding operations on the component class nodes in response to hierarchy model commands to obtain the hierarchy model;
   2) constructing the interface models: construct an interface model for each component class of the hierarchy model obtained in the step 1), the steps for constructing each interface model including: the interface mold reads in interface model commands from the actual system modeling environment, wherein interface model commands refers to commands such as creating, naming, and deleting the attributes, the functions, and the events, wherein the interface mold performs corresponding operations in response to interface model commands to obtain the interface model, and wherein the algorithm models for implementing algorithm functions are constructed by step 3) and process models for implementing process functions are constructed by the step 4);
   3) constructing the algorithm models: constructing an algorithm model for each algorithm function obtained in the step 2), the steps for constructing each algorithm model including: the algorithm mold reads in algorithm model commands from the actual system modeling environment;
   4) constructing the process models: constructing a process model for each process function obtained in the step 2), the steps for constructing each process model including: the process mold reads in process model command from the actual system modeling environment; and
   5) constructing the transfer models: constructing a transfer model for each action in the process model obtained in the step 4), the steps for constructing each transfer model including: the transfer mold reads in transfer model commands from the actual system modeling environment, wherein transfer model commands refers to commands on such as adding a transfer, adding a transfer, and deleting a transfer and wherein the transfer mold performs corresponding operations in response to transfer model commands to obtain the transfer model.

Thereby the system model constructed by a hierarchy model, interface models, algorithm models, process models, and transfer models is accomplished.

The system meta model applies the following modeling rules:
a combination of the process mold and the transfer mold provide a universal means to describe and configure functions; the algorithm mold provides a simplified alternative for replacing the combination of the process mold and the transfer mold if only operators are used to implement the functions;
the system meta model employs a parent-child structure as base recursive unit to recursively describe the system model. The parent-child structure refers to a structure of parent-child relationships in a hierarchy tree, constituted by node of involved component class and all nodes of child component classes thereof;
the specific function of the step 2) can only be either algorithm function or process function, not both;
algorithm model commands stated in the step 3) refers to commands, such as adding an operator, selecting an operator, naming an operator, as well as adding an assignment, selecting an assignment, and deleting an assignment, and the algorithm mold performs corresponding operations in response to the algorithm model commands to obtain the algorithm model. The operators include logic operators with logic functions and computation operators with calculation functions; a tree structure which nodes are operators is referred to as an algorithm tree. The said assignment refers to an assignment relationship between two attributes in a set of the algorithm attributes, and the set of the algorithm attributes refers to a collection constituted by an attribute set of the involved component classes and an attribute set of all of operators in the algorithm model;
process model commands to construct the process model in step 4) refers to commands such as adding an action, selecting an action, naming an action, and deleting an action and the process mold performs a corresponding operation in response to the process model commands to obtain the process model. The actions include both component actions and operator actions; said component action refers to one execution of the functions in the function set in the parent-child structure, the function set in the parent-child structure refers to a collection constituted by the function set of the involved component class and function sets of all child component classes in the parent-child structure; operator actions refers to one execution of operator's function; process models include both an attribute process model and an event process model, the process mold includes both attribute process molds and event process molds, attribute process mold describes the attribute process model through a process tree as the structure, which is a tree structure constituted by actions as nodes. an event process mold describes an event process model by a set of event associations as the structure; an event association in the set of event associations is an association relationship between an event in an event set in a parent-child structure and an operator action or a component action. The event set in the parent-child structure is the event set of the involved component class and event sets of all of child component classes in the parent-child structure.

Besides action attributes which refers to the attribute of the component class where the action is, said attributes relevant to transfers are limited to the parent-child attribute set, which refers to a collection constituted by the attribute set of the involved component classes and attribute sets of all of child component classes in the parent-child structure;
thus, after determining basic constituents of the system meta model, the present invention constructs system models through hierarchy model, interface models, algorithm models, process models, and transfer models as step features and thereby provides a specification for system modeling in various fields; such specification has advantages including generality and convenience; system models constructed through the present invention are executable, have clear structures, adjustable hierarchies, and controllable granularities; this method supports both top-down analysis and bottom-up integration for modeling in various systems including software systems and information systems. The quantity of required elements for modeling is small and the modeling method is simple, thereby even those not skilled in any modeling language nor computer programming language can easily and independently construct the system model, eliminating the tedious and unnecessary communication with and dependence on professional modelers and application developers, greatly reducing modeling time.

In summary, the present invention has obvious advantages over the prior art as follows:
(1) executability: the system model constructed according to the present invention is executable, that is, has an integrity and a full consistency in which the system model can be mapped to a program executable by a computer;
(2) generality: the system model constructed according to the present invention has a clear structure, adjustable hierarchies, controllable granularities, and generality suitable for all types of systems. That is, not only suitable for algorithm modeling but also rapid prototyping of the system and even more suitable for large, complex system modeling; not only convenient for top-down analysis but also bottom up integration; not only suitable for system integration based on prefabricated units and system expansion based on customized units, but also suitable for distributed systems' interconnection and communication; not only suitable for practical engineering modeling, but also suitable for software system and information system modeling; not only suitable for equipment information systems' simulation modeling, but also suitable for MIS(management information system)'s modeling; not only suitable for desktop software system modeling, embedded device software system modeling, mobile terminal software system modeling, but also suitable for LAN software system modeling, WAN software system modeling, and cloud computation environmental software system modeling; not only suitable for applied software system modeling, but also suitable for software development environment modeling; and
(3) ease of use: the elements of the present invention are concise, rules thereof are simple, and methods thereof are universal. Even those not skilled in any complex modeling language nor any computer programming language can easily take advantage of the present invention to construct the system model with executability in a relatively short period of time, eliminating the tedious and unnecessary communication with and dependence on professional modelers and application developers, enabling the resultant system model to be more fitted to the expectations of those skilled in this art, and eliminating possible understanding errors of the professional modelers or the application developers; at the same time, because communication time is saved, modeling time is greatly reduced.

### BRIEF DESCRIPTION OF THE DRAWINGS

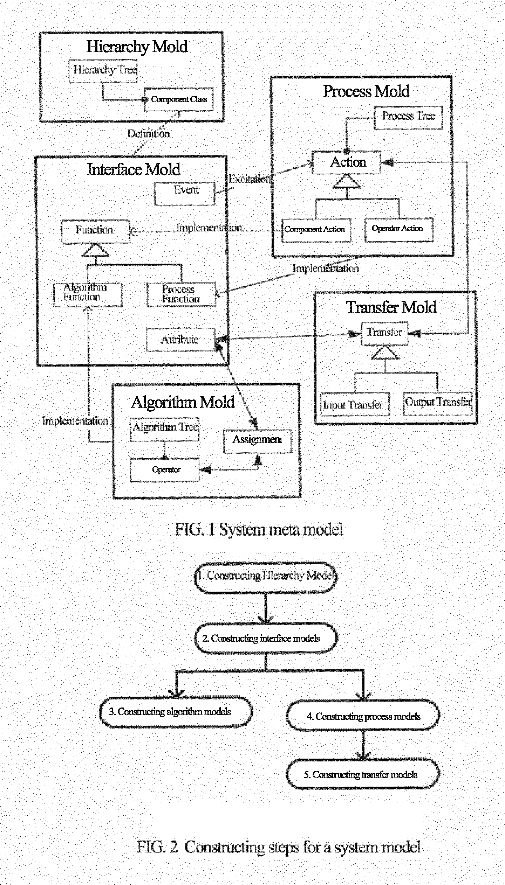

Fig. 1 is the system meta model.
Fig. 2 is construction steps of a system model.

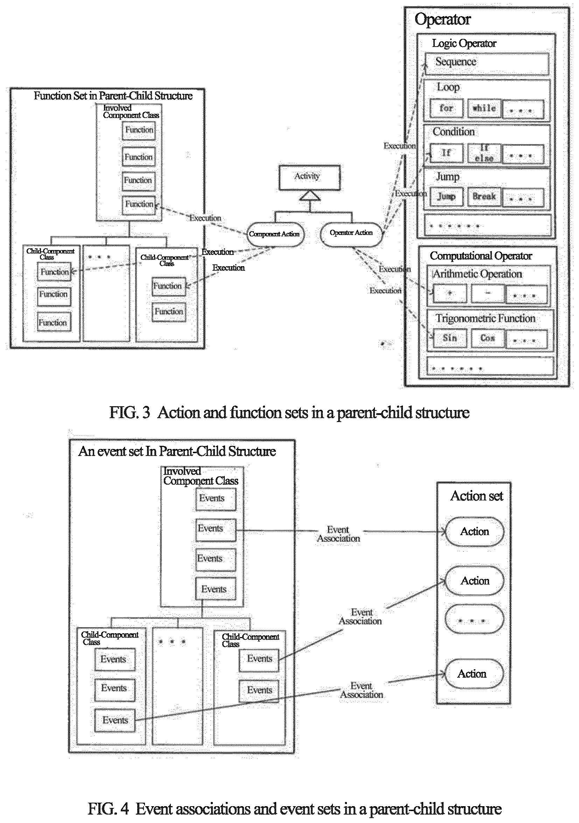

Fig. 3 is an action and function sets in a parent-child structure
Fig. 4 is event associations and event sets in a parent-child structure.
Fig. 5 is transfers and attribute set in a parent-child structure.
Fig. 6 is a computer for implementing method for general modeling basing on system meta model to construct a system model.
Fig. 7 is business management YWGL model's hierarchy model.
Fig. 8 is the business management YWGL interface model.
Fig. 9 is the sales management XSGL interface model.
Fig. 10 is the production management SCGL interface model.
Fig. 11 is the purchase management CGGL interface model.
Fig. 12 is the distributed sales products FXP interface model.
Fig. 13 is the direct sales products ZXP interface model.
Fig. 14 is the main parts ZJ interface model.
Fig. 15 is the auxiliary parts LJ interface model.
Fig. 16 is the finished products CP interface model.
Fig. 17 is the main parts processing algorithm model
Fig. 18 is the main parts delivery algorithm model.
Fig. 19 is the auxiliary parts processing algorithm model.
Fig. 20 is the auxiliary parts delivery algorithm model.
Fig. 21 is the parts receipt algorithm model.
Fig. 22 is the finished products assembly algorithm model.
Fig. 23 is the main business procedure process model.
Fig. 24 is the business configuration process model.
Fig. 25 is the business operation process model.
Fig. 26 is the internal order process model.
Fig. 27 is the sales shipment process model.
Fig. 28 is the sales order process model.
Fig. 29 is the production planning process model.
Fig. 30 is the production implementation process model.
Fig. 31 is the products delivery process model.
Fig. 32 is the business operation loop transfer model.
Fig. 33 is the serial number reset assignment transfer model.
Fig. 34 is the production instance creation transfer model.
Fig. 35 is the production configuration traversal process model.
Fig. 36 is the production serial number increment transfer model.
Fig. 37 is the production serial number assignment transfer model.
Fig. 38 is the purchase instance creation transfer model.
Fig. 39 is the purchase configuration traversal transfer model.
Fig. 40 is the purchase serial number increment transfer model.
Fig. 41 is the purchase serial number assignment transfer model.
Fig. 42 is the sales serial number reset assignment transfer model.
Fig. 43 is the sales instance creation transfer model.
Fig. 44 is the sales configuration traversal transfer model.
Fig. 45 is the sales serial number increment transfer model.
Fig. 46 is the sales serial number assignment transfer model.
Fig. 47 is the sales-production configuration traversals transfer model.
Fig. 48 is the sales-production configuration comparison transfer model.
Fig. 49 is the sales-production configuration condition transfer model.
Fig. 50 is the sales-production assignment transfer model.
Fig. 51 is the sales-purchase configuration traversals transfer model.
Fig. 52 is the sales-purchase configuration comparison transfer model.
Fig. 53 is the sales-purchase configuration condition transfer model.
Fig. 54 is the sales-purchase configuration transfer model.
Fig. 55 is the production operation traversal transfer model.
Fig. 56 is the purchase operation traversal transfer model.
Fig. 57 is the sales operation traversal transfer model.
Fig. 58 is the sales production operation traversal transfer model.
Fig. 59 is the sales-production operation comparison transfer model.
Fig. 60 is the sales-production operation condition transfer model.
Fig. 61 is the production-sales receipt transfer model.
Fig. 62 is the production internal order transfer model.
Fig. 63 is the sales-purchase traversal transfer model.
Fig. 64 is the comparison of sales-purchase operations comparison transfer model.
Fig. 65 is the sales-purchase operation condition transfer model.
Fig. 66 is purchase-sales receipt transfer model.
Fig. 67 is the purchase internal order transfer model.
Fig. 68 is the contract summary transfer model.
Fig. 69 is the demand summary transfer model.
Fig. 70 is the order summary transfer model.
Fig. 71 is the shipment summary transfer model.
Fig. 72 is the inventory summary transfer model.
Fig. 73 is the receipt summary transfer model.
Fig. 74 is the main-parts pending processing summary transfer model.
Fig. 75 is the auxiliary parts pending processing summary transfer model.
Fig. 76 is the parts receipt transfer model.
Fig. 77 is the finished products assembly transfer model.
Fig. 78 is the completed products delivery transfer model.
Fig. 79 is the total delivery quantity summary transfer model.

In the drawings listed above, the figure showing transfer model emphasized the involved action's transfer model using boldface font. Meanwhile, for the convenience of reading, the non-boldface figures in the drawings represent information regarding involved actions.

### DETAILED DESCRIPTION OF THE INVENTION

Below, a further detailed description of the present invention will be given in conjunction with the accompanying drawings and a specific embodiment, wherein a computer generally comprises a central processor, a memory, an Input and Output (I/O) interface, and a bus; and furthermore, the computer is connected with an input and output device and a storage medium. The central processor takes charge of functions of computing and controlling the computer. The central processor may only include one central processing unit, or may include a plurality of central processing units distributed at one or more positions.

The memory medium may be formed by any known computer readable storage medium. For example, a buffer memory may temporarily store some program codes so as to reduce time for extracting codes from a large-capacity memory when the program is run. In the meantime, the memory may reside at a certain physical position, and may be stored in one or more types of data, or may be distributed in different physical systems in different forms. Moreover, the memory may also be distributed in a Local Area Network (LAN) or a Wide Area Network (WAN). The memory may contain program codes for implementing a general modeling method to establish a system view based on a system meta view, or may contain other codes not shown in the diagram, such as an operating system.

The input and output interface allows the computer to exchange information with the storage medium or another computer. The input and output device contains any known external device type, such as a display device, a keyboard, a mouse, a printer, a sound box, a handheld device, and a facial mask, etc. The bus provides communication connection among respective component parts inside the computer, including a variety of transmission connection forms such as electrical, optical, wireless and other forms. The storage medium includes any known computer readable storage medium, such as a magnetic disc, an optical disc, etc. The storage medium may contain one or more examples of a general system view established by the system meta view.

A person skilled in the art can know that the present invention can be implemented as an all hardware product, an all software product, or a combination of hardware and software, which is commonly referred to as a module. Moreover, the present invention can be implemented by a computer program product stored in the computer readable medium. The computer readable medium may be, for example, but not limited to an electrical, a magnetic, an optical, an electromagnetic, an infrared or a semiconductor system, apparatus, or device or any combination of the above, and more particularly, the computer readable medium includes, but not limited to, the following: a random access memory (RAM), a read-only memory (ROM), an erasable and programmable read-only memory (EPROM or flash memory), a CD-ROM, an optical storage device, a magnetic storage device, and any combination of the above.

The computer program codes for implementing the method of the present invention can be programmed by one or more programming languages, including, for example, Java, Small, C++, C# and so on, and other process-oriented programming languages such as C. The program codes can be run on a personal computer, a handheld device, or an LAN or WAN.

A person skilled in the art surely knows that the method of the present invention may also be expressed by graphical representations, and such graphical representations all can be implemented as computer program codes, which can be processed by a general-purpose computer, a special-purpose computer and other programmable data processing apparatuses, to achieve the functions indicated by these graphical representations.

In the following embodiments, in order to maintain the completeness of description of a system model, the transfer models for all actions are listed. Among these, some of the actions do not require transfers of the data, and thereby the content of such a transfer model is null which will be expressed as the word "null".

The embodiment is related to constructing a business management YWGL model. It should be noted that this embodiment is merely an example of a specific application of the present invention and the technical essence of the present invention is not limited to this example.

### Embodiment: constructing the business management YWGL model

Suppose the firm's business model is to profit from selling its own products and outsourcing products, the present embodiment will model the business management system for achieving the following intentions:
(1) clearly distinguishing three modules: production management, purchase management, and sales management;
(2) configuration: configure the number of sales product types from number of production product types and purchase product types; and
(3) execution function: the sales management module monitors contract order quantities and shipment quantities of the direct sales and distributed sales of each type of products, receives delivery information from the production management module and the purchase management module, and issues order information to the production management module and the purchase management module based on the sales status; the production management module and the purchase management module receive order information from the sales management module, start an internal process, and submit the delivery information to the sales management module.

The detailed process for constructing this embodiment's system model is given below.

### Constructing the hierarchy model

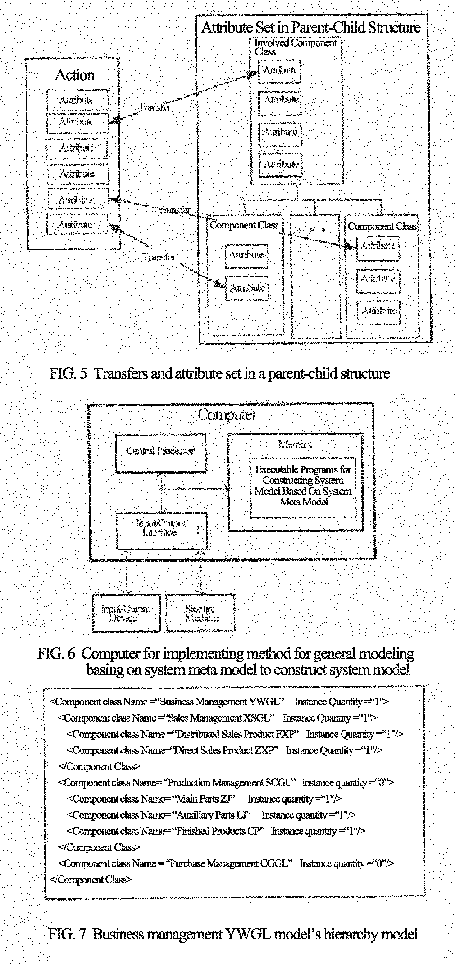

Fig. 7 shows a completed hierarchy model of the business management YWGL model.

The detailed process for constructing this hierarchy model according to this embodiment is given below:
At the initial state before start of modeling, the hierarchy mold creates a default component class as the root node of a hierarchy tree for the business management YWGL model, wherein the component class of the root node is referred to as a root component class;
the hierarchy mold receives command to select root component class from the actual system modeling environment and sets the root component class as the involved component class in response to the foregoing command; the hierarchy mold receives command to modify component class' name attribute to "business management YWGL" from the actual system modeling environment and modifies the name of the root component class to "business management YWGL" in response to the foregoing command; the involved component class is referred to as business management YWGL component class in accordance with the name of the root component class and name for the other component classes may be deduced by analogy; the hierarchy mold receives command to set the component instance number to 1 from the actual system modeling environment and sets the component instance number of the business management YWGL component class to 1 in response to the foregoing command;
the hierarchy mold receives and responds to command, from the actual system modeling environment, to add a child component class for business management YWGL component class; the hierarchy mold sets the foregoing child component classes as the involved component class; the hierarchy mold receives and responds to commands from the actual system modeling environment, modifies the name of the involved component class to "sales management XSGL" and sets the number of component instances of the sales management XSGL component class to 1;
in the foregoing steps, hierarchy mold adds two child component classes, production management SCGL component class and purchase management CGGL component class to business management YWGL component class, and sets both of child component classes' component instance number to 0;
in the foregoing steps, hierarchy mold adds two child component classes, distributed sales products FXP component class and direct sales products ZXP component class to sales management XSGL component class, both of the component instance number are 1; and
in the foregoing steps, hierarchy mold adds child component classes: main parts ZJ component class, auxiliary parts LJ component class, and finished products CP component class, whose numbers of component instances are 1 to the production management SCGL component class.

So far, the hierarchy model of the present embodiment is accomplished.

### Constructing the interface models

Next, the processes for constructing the interface model for each of the component classes in the hierarchy model will be given.

### Business management YWGL interface model

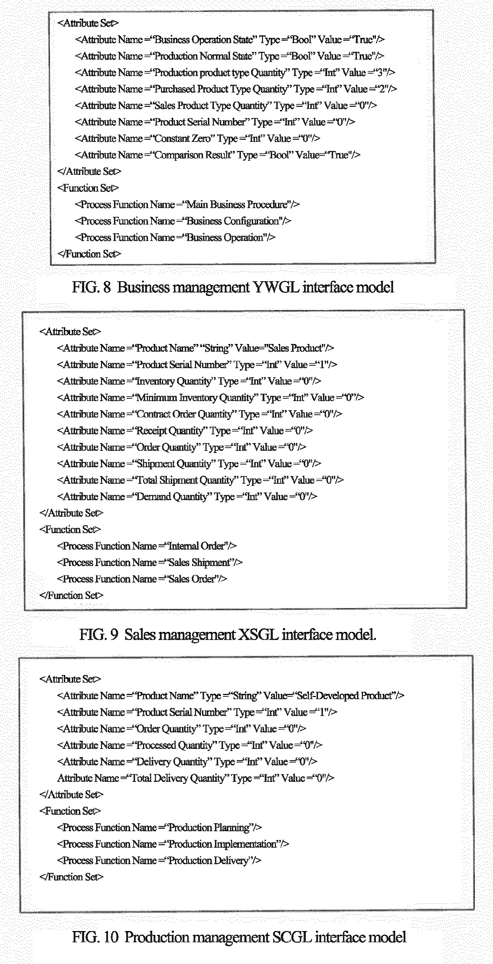

Fig. 8 shows a completed interface model for business management YWGL component class, which is shortly referred to as business management YWGL interface model in accordance with the name of the component class, name of other interface models may be deduced by analogy. The processes for constructing business management YWGL interface model are as follows:
the hierarchy mold receives and responds to command from the actual system modeling environment and sets business management YWGL component class to the involved component class;
the interface mold receives and responds to command from the actual system modeling environment by executing the following corresponding operations: adding a new attribute for business management YWGL interface model; setting the foregoing new attribute as the involved attribute; modifying the data type of the involved attribute to "bool"; modifying the attribute name of the involved attribute to business operation state, wherein such attribute name for the business operation state is referred to business operation state attribute, and names for the subsequent attributes may be deduced by analogy, which will not be repeated below; and setting the attribute value of the business operation state to "true";
in the foregoing steps, adding the following attributes to the business management YWGL interface model: a production normal state attribute whose data type is "bool" and the attribute value is "true"; a production product type quantity whose data type is "int" and attribute value is "3"; a purchased product type quantity attribute whose data type is "int" and attribute value is "2"; a sales product type quantity attribute whose data type is "int" and attribute value is "0"; a product serial number attribute whose data type is "int" and attribute value is "0"; a constant zero attribute whose data type is "int" and attribute value is "0"; and a comparison result attribute whose data type is "bool" and the attribute value is "true";
the interface mold receives and responds to command from the actual system modeling environment to execute the following corresponding operations: adding a process function for business management YWGL interface model; setting the foregoing function as the involved function; modifying the name of the involved function to "main business procedure", wherein such a function is shortly referred to as the main business procedure function, names for the subsequent functions may be deduced by analogy and will not be repeated below; and
in the foregoing steps, adding the process functions such as business configuration function and business operation function for business management YWGL interface model.

So far, the business management YWGL interface model is accomplished.

### Sales management XSGL interface model

Fig. 9 shows a completed sales management XSGL interface model whose construction process is similar to that of the "business management YWGL interface model" and the content thereof is as follows:
the attribute set contains: a product name attribute whose data type is "string" and attribute value is "sales product"; a product serial number attribute whose data type is "int" and attribute value is "1"; an inventory quantity attribute whose data type is "int"and attribute value is "0"; a minimum inventory quantity attribute whose data type is "int" and attribute value is "0"; a contract order quantity attribute whose data type is "int" and attribute value is "0"; a receipt quantity attribute whose data type is "int" and attribute value is "0"; an order quantity attribute whose data type is "int" and attribute value is "0"; a shipment quantity attribute whose data type is "int" and attribute value is "0"; a total shipment quantity attribute whose data type is "int" and attribute value is "0"; and a demand quantity attribute whose data type is "int" and attribute value is "0"; and
the function set contains three process functions: internal order function, sales shipment function, and sales order function.

### Production management SCGL interface model

Fig. 10 shows a completed production management SCGL interface model whose construction process is similar to that of "business management YWGL interface model" and the content thereof is as follows:
the attribute set contains: a product name attribute whose data type is "string" and attribute value is "self-developed product"; a product serial number attribute whose data type is "int" and attribute value is "1"; an order quantity attribute whose data type is "int" and attribute value is "0"; a processed quantity attribute whose the data type is "int" and attribute value is "0"; a delivery quantity attribute whose data type is "int" and attribute value is "0"; and a total delivery quantity attribute whose the data type is "int"and attribute value is "0"; and
the function set contains three process functions: production planning function, production implementation function, and production delivery function.

### Purchase management CGGL interface model

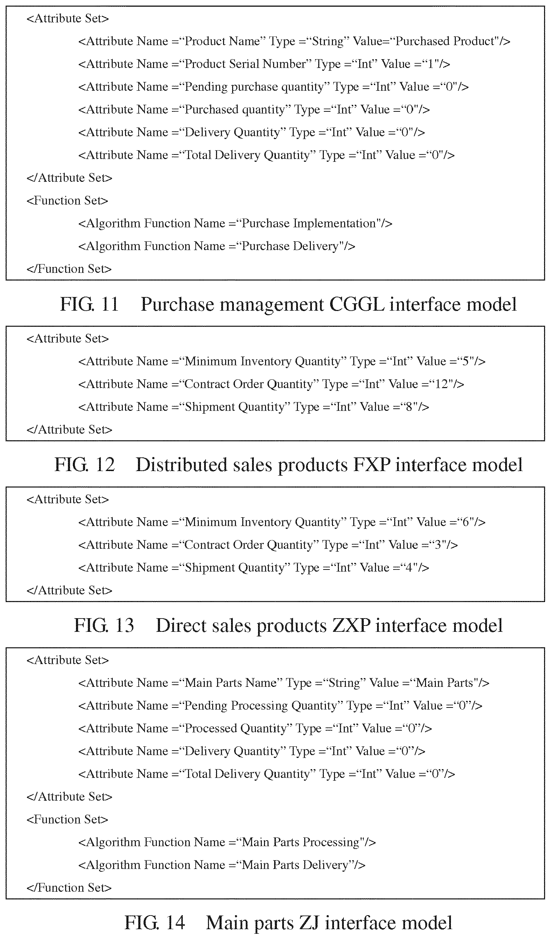

Fig. 11 shows a completed purchase management CGGL interface model whose construction process is similar to that of "business management YWGL interface model" and the content thereof is as follows:
the attribute set contains: a product name attribute whose data type is "string" and attribute value is "purchased product"; a product serial number attribute whose data type is "int" and attribute value is "1"; a pending purchase quantity attribute whose data type is "int" and attribute value is "0"; a purchased quantity attribute whose data type is "int" and attribute value is "0"; a delivery quantity attribute whose data type is "int" and attribute value is 0; and a total delivery quantity attribute whose data type is "int" and attribute value is "0" the; and
the function set contains two algorithms functions, i.e., purchase implementation function and purchase delivery function.

### Distributed sales products FXP interface model

Fig. 12 shows a completed distributed sales products FXP interface model whose construction process is similar to that of "business management YWGL interface model" and the content thereof is as follows:
the attribute set contains: a minimum inventory quantity attribute whose data type is "int" and attribute value is "5"; a contract order quantity attribute whose data type is "int" and attribute value is "12"; and a shipment quantity attribute whose data type is "int" and attribute value is "8".

### Direct sales products ZXP interface model

Fig. 13 shows a completed direct sales products ZXP interface model whose construction process is similar to that of "business management YWGL interface model" and the content thereof is as follows:
the attribute set contains: a minimum inventory quantity attribute whose data type is "int" and attribute value is "6"; a contract order quantity attribute whose the data type is "int" and attribute value is "3"; and a shipment quantity attribute whose the data type is "int" and attribute value is "4".

### Main parts ZJ interface model

Fig. 14 shows a completed main parts ZJ interface model whose construction process is similar to that of "business management YWGL interface model" and the content thereof is as follows:
the attribute set contains: a main parts name attribute whose data type is "string" and attribute value is "main parts"; a pending processing quantity attribute whose data type is "int"and attribute value is "0"; a processed quantity attribute whose data type is "int"and attribute value is "0"; a delivery quantity attribute whose data type is "int"and attribute value is "0"; and a total delivery quantity attribute whose data type is "int" and attribute value is "0"; and
the function set contains two algorithm functions: main parts processing function and main parts delivery function.

### Auxiliary parts LJ interface model

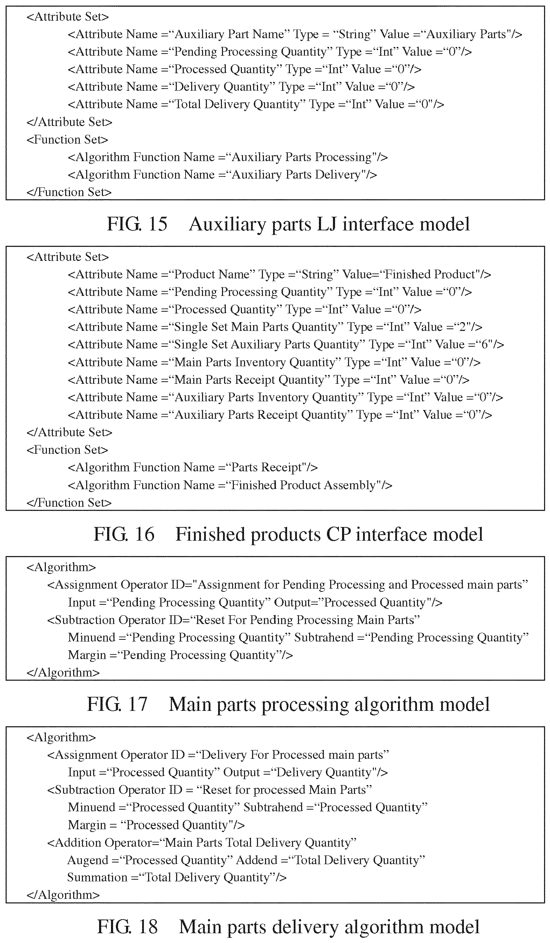

Fig. 15 shows a completed auxiliary parts LJ interface model whose construction process is similar to that of "business management YWGL interface model" and the content thereof is as follows:
the attribute set contains: an auxiliary parts name attribute whose data type is "string" and attribute value is "auxiliary parts"; a pending processing quantity attribute whose data type is "int"and attribute value is "0"; a processed Quantity whose data type is "int" and attribute value is "0"; a delivery quantity attribute whose the data type is "int" and attribute value is "0"; and a total delivery quantity attribute whose data type is "int" and attribute value is "0"; and
the function set contains two algorithm functions: auxiliary parts processing function and auxiliary parts delivery function.

### Finished products CP interface model

Fig. 16 shows a completed finished products CP interface model whose construction process is similar that of "business management YWGL interface model" and the content thereof is as follows:
the attribute set contains: a finished product name attribute whose data type is "string" and attribute value is "finished product"; a pending processing quantity attribute whose data type is "int" and attribute value is "0", a processed quantity attribute whose data type is "int"and attribute value is "0"; a single set main parts quantity attribute whose data type is "int" and attribute value is "2"; a single set auxiliary parts quantity attribute whose data type is "int"and attribute value is "6"; a main parts inventory quantity attribute whose data type is "int" and attribute value is "0"; a main parts receipt quantity attribute whose data type is "int" and attribute value is "0";an parts inventory quantity attribute whose data type is "int" and attribute value is "0"; and a parts receipt quantity attribute whose data type is "int" and attribute value is "0"; and
the function set contains two algorithm functions: parts receipt function and finished product assembly function.

### Constructing the algorithm models

Next, the construction process of each of the algorithm models will be described in detail.

### Main parts processing algorithm model

Fig. 17 shows a completed main parts processing algorithm model whose construction process is as follows:
the hierarchy mold receives and responds to command from the actual system modeling environment to set main parts ZJ component class as the involved component class;
the interface mold receives and responds to command from the actual system modeling environment to set the main parts processing function as the involved function, wherein the algorithm model for accomplishing the main parts processing function is shortly referred to main parts processing algorithm model in accordance with the function name; naming of the subsequent algorithm models for other functions may be deduced by analogy, which will not be repeated below;
the algorithm mold receives and responds to command from the actual system modeling environment by executing the following corresponding operations: adding an assignment operator which is referred to as an assignment operator for pending processing and processed main parts; establishing an assignment from the pending processing quantity attribute of main parts ZJ component class to the input attribute of the assignment operator for pending processing and processed main parts; establishing an assignment from the output attribute of the assignment operator for pending processing and processed main parts to the processed quantity attribute of the main parts ZJ component class; and
in the foregoing steps, adding a subtraction operator which is referred to as a reset operator for pending processing main parts; establishing an assignment from the pending processing quantity attribute of main parts ZJ component class to the minuend attribute of reset operator for pending processing main parts; establishing an assignment from the pending processing quantity attribute of main parts ZJ component class to the subtrahend attribute of the reset operator for pending processing main parts; and establishing an assignment from the margin attribute of reset operator for pending processing main parts to the pending processing quantity attribute of main parts ZJ component class.

So far, the algorithm model for main parts processing function is accomplished.

### Main parts delivery algorithm model

Fig. 18 shows a completed main parts delivery algorithm model whose construction process is similar to that of "main parts processing algorithm model" and the content thereof is as follows:
an assignment operator which is referred to as a delivery operator for processed main parts has the following assignments: from the processed quantity attribute of the main parts ZJ component class to the input attribute of the delivery operator for completed main-parts; and from the output attribute of the delivery operator for processed main parts to the delivery quantity attribute of main parts ZJ component class;
a subtraction operator which is referred to as a reset operator for processed main parts has the following assignments: from the processed quantity attribute of the main parts ZJ component class to the minuend attribute of reset operator for completed main-parts; from the processed quantity attribute of main parts ZJ component class to the subtrahend attribute of reset operator for completed main-parts; and from the margin attribute of reset operator for processed main parts to the processed quantity attribute of main parts ZJ component class; and
an addition operator which is referred to as a main parts total delivery quantity operator has the following assignments: from the processed quantity attribute of the main parts ZJ component class to the augend attribute of the main parts total delivery quantity operator; from the total delivery quantity attributes of main parts ZJ component class to the addend attribute of the main parts total delivery quantity operator; and from the summation attribute of the main parts total delivery quantity operator to the total delivery quantity attribute of main parts ZJ component class.

### Auxiliary parts processing algorithm model

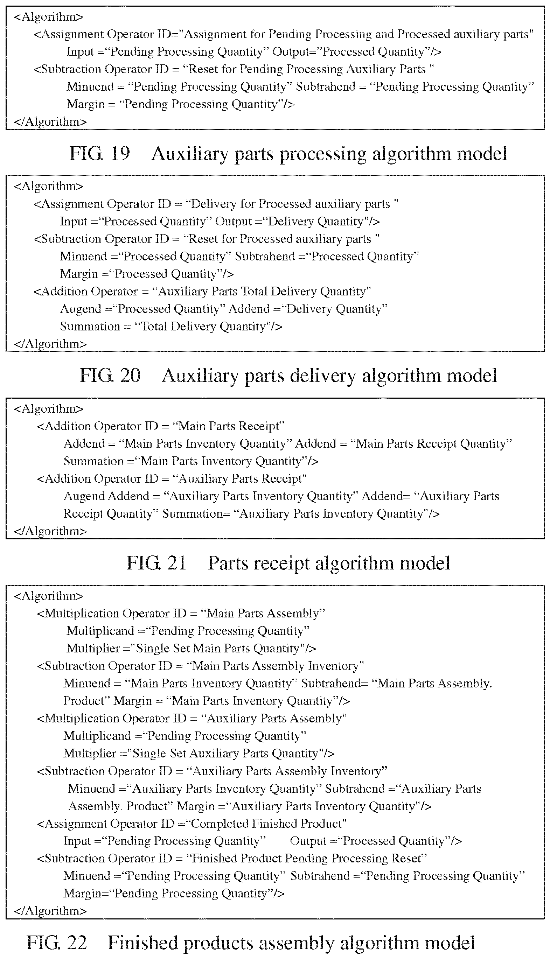

Fig. 19 shows a completed auxiliary parts processing algorithm model whose construction process is similar to "that of main parts processing algorithm model" and the content thereof is as follows:
an assignment operator which is referred to as assignment operator for pending processing and processed auxiliary parts has the following assignments: from the pending processing quantity attribute of the auxiliary parts LJ component class to the input attribute of the assignment operator for pending processing and processed auxiliary parts; and from the output attribute of the assignment operator for pending processing and processed auxiliary parts to the pending processing quantity attribute of the auxiliary parts LJ component class;
a subtraction operator which is referred to as reset operator for pending processing auxiliary parts has the following assignments: from the pending processing quantity attribute of auxiliary parts LJ component class to the minuend attribute of the reset operator for pending processing auxiliary parts; from the pending processing quantity attribute of auxiliary parts LJ component class to the subtrahend attribute of the reset operator for pending processing auxiliary parts; and from the margin attribute of the reset operator for pending processing auxiliary parts to the pending processing quantity attribute of auxiliary parts LJ component class.

### Auxiliary parts delivery algorithm model

Fig. 20 shows a completed auxiliary parts delivery algorithm model whose construction process is similar to that of "main parts processing algorithm model" and the content thereof is as follows:
an assignment operator which is referred to as a delivery operator for processed auxiliary parts has the following assignments: from the processed quantity attribute of the auxiliary parts LJ component class to the input attribute of the delivery operator for processed auxiliary parts; and from the output attribute of the delivery operator for processed auxiliary parts to the delivery quantity attribute of auxiliary parts LJ component class;
a subtraction operator which is referred to as a reset operator for processed auxiliary parts has the following assignments: from the processed quantity attribute of the auxiliary parts LJ component class to the minuend attribute of reset operator for processed auxiliary parts; from the processed quantity attribute of auxiliary parts LJ component class to the subtrahend attribute of reset operator for processed auxiliary parts; and from the margin attribute of reset operator for processed auxiliary parts to the processed quantity attribute of auxiliary parts LJ component class; and
an addition operator which is referred to as an auxiliary parts total delivery quantity operator has the following assignments: from the processed quantity attribute of the auxiliary parts LJ component class to the augend attribute of the auxiliary parts total delivery quantity operator; from the total delivery quantity attributes of auxiliary parts LJ component class to the addend attribute of the auxiliary parts total delivery quantity operator; and from the summation attribute of the auxiliary parts total delivery quantity operator to the total delivery quantity attribute of auxiliary parts LJ component class.

### Parts receipt algorithm model

Fig. 21 shows a completed parts receipt algorithm model whose construction process is similar to that of "main parts processing algorithm model" and the content thereof is as follows:
an addition operator which is referred to as a main parts receipt operator has the following assignments: from the main parts inventory quantity attribute of the finished products CP component class to the augend attribute of the main parts receipt operator; from the main parts receipt quantity attribute of the finished products CP component class to the addend attribute of the main parts receipt operator; and from the sum attribute of the main parts receipt operator to the main parts inventory quantity attribute of the finished products CP component class;
an addition operator which is referred to as an auxiliary parts receipt operator has the following assignments: from the auxiliary parts inventory quantity attribute of the finished products CP component class to the augend attribute of the auxiliary parts receipt operator; from the auxiliary parts receipt quantity attribute of the finished products CP component class to the addend attribute of the auxiliary parts receipt operator; and from the sum attribute of the auxiliary parts receipt operator to the auxiliary parts inventory quantity attribute of the finished products CP component class.

### Finished product assembly algorithm model

Fig. 22 shows a completed finished product assembly algorithm model whose construction process is similar to that of the "main parts processing algorithm model " and the content thereof is as follows:
a multiplication operator which is referred to as main parts assembly operator has the following assignments: from the finished products CP component class' pending processing quantity attribute to the multiplicand attribute of the main parts assembly operator; and from the single set main parts quantity attribute of the finished products CP component class to the multiplier attribute of the main parts assembly operator;
a subtraction operator which is referred to as main parts assembly inventory operator has the following assignments: from the main parts inventory quantity attribute of the finished products CP component class to the minuend attribute of the main parts assembly inventory operator; from the product attribute of the main parts assembly inventory operator to the subtrahend attribute of the main parts assembly inventory operator; and from the margin attribute of the main parts assembly inventory operator to the main parts inventory quantity attribute of the finished products CP component class;
a multiplication operator which is referred to as an auxiliary-parts assembly operator has the following assignments: from the pending processing quantity attribute of the finished products CP component class to the multiplicand attribute of the auxiliary parts assembly operator; and the single set auxiliary parts quantity attribute of the finished products CP component class to the multiplier attribute of the auxiliary parts assembly operator;
a subtraction operator which is referred to as auxiliary parts assembly inventory operator has the following assignments: from the auxiliary parts inventory quantity attribute of the finished products CP component class to the minuend attribute of the auxiliary parts assembly inventory operator; and from the product attribute of the auxiliary-parts assembly inventory operator to the subtrahend attribute of the auxiliary parts assembly inventory operator; and from the margin attribute of the auxiliary parts assembly inventory operator to the auxiliary parts inventory quantity attribute of the finished products CP component class;
an assignment operator which is referred to as finished product processed operator has the following assignments: from the pending processing quantity attribute of the finished products CP component class to the input attribute of the finished product processed operator; and from the output attribute of the finished product processed operator to the finished products CP component class' processed quantity attribute;
a subtraction operator which is referred to as finished product pending processing reset operator has the following assignments: from the finished products CP component class' pending processing quantity attribute to the minuend attribute of the finished product pending processing reset operator; from the pending processing quantity attribute of the finished products CP component class to the subtrahend attribute of the finished product pending processing reset operator; and from the margin attribute of the finished product pending processing reset operator to the pending processing quantity attribute of the finished products CP component class.

So far, all algorithms models in this embodiment are accomplished.

### Constructing the process models

Next, the construction process of each process model will be described in detail.

### Main business procedure process model

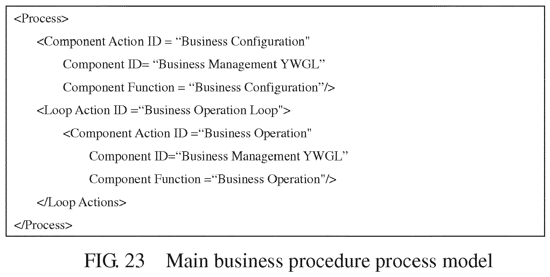

Fig. 23 shows a completed main business procedure process model for the business management YWGL component class. It is constructed as follows:
the hierarchy mold receives and responds to command from the actual system modeling environment to set the business management YWGL component class as the involved component classes;
the interface mold receives and responds to the command from the actual system modeling environment to set the main business procedure function as the involved function, wherein the process model of the main business procedure function is shortly referred to as main business procedure process model in accordance with the function name and names of process models for the other functions may be deduced by analogy, which will not be repeated below;
the process mold first creates a sequential action as the root action for the main business procedure process model, wherein the sequential action is a logic action with sequential execution function, has a start node and an end node, and may sequentially add other actions between the start node and the end node, and wherein the root action is referred to as main business procedure root action in accordance with the name of the process model; it should be noted that the process mold creates a root action for each process model, of which the name of the root action may be deduced by analogy and will not be repeated below;
the process mold receives and responds to command from the actual system modeling environment to add an action based on a business configuration function of the business management YWGL component class, based the name of function executed by the action, the action is shortly referred to as business configuration action and names for subsequent actions may be deduced by analogy, which will not be repeated below; and the process mold adds a business configuration action in the main business procedure root action in response to the foregoing command;
in the foregoing steps, in the main business procedure root action, add a loop action, which is shortly referred to as business operation loop action, is an operator action with a loop function, and comprises a loop sequence inside, wherein the loop sequence consists of a plurality of nodes that contain actions;
in the foregoing steps, add an action based on the business management YWGL component class' business operation function in the business operation loop action's loop sequence, wherein such action is shortly referred to as business operation action.

So far, the main business procedure process model is accomplished.

### Business configuration process model

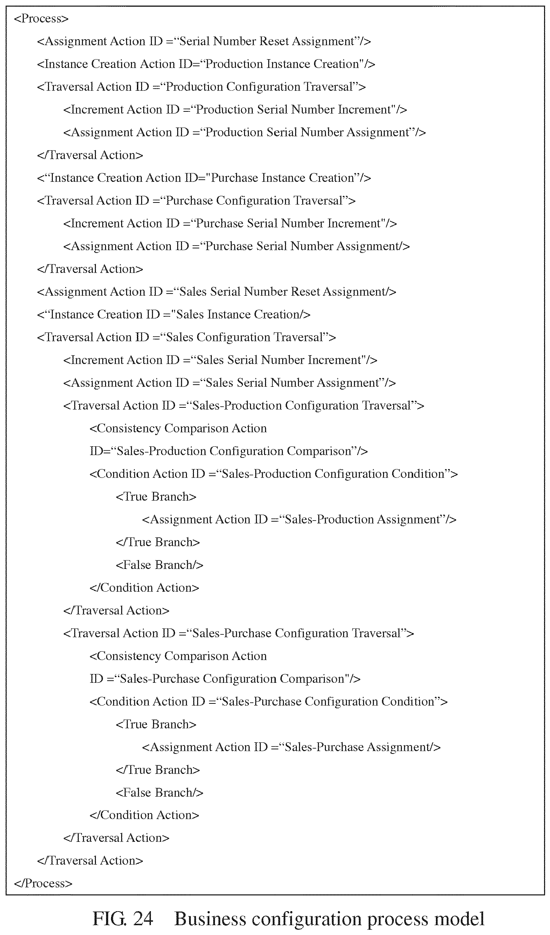

Fig. 24 shows a completed business configuration process model for the business management YWGL component class whose construction process is similar to that of the "main business procedure process model" and the content thereof is as follows:
add an assignment operator action, shortly referred to as serial number reset assignment action, in the business configuration root action; wherein the assignment operator action is an operator action with an assignment function; add an instance creation operator action, shortly referred to as production instance creation action, in the business configuration root action, wherein the instance creation operator action is an operator action with component instance creation functions; add a traversal action, shortly referred to as production configuration traversal action, in the business configuration root action, wherein the traversal action comprises of a node sequence, with each node accommodating one action; and wherein the traversal action refers to an operator action where the node sequence is only executed once on each of component instances of a certain component class;
add an increment action, shortly referred to as a production serial number increment action, in the production configuration traversal action's traversal sequence, wherein the increment action refers to an operator action with a prefabricated function that increments integers by one; add an assignment action, shortly referred to as production serial number assignment action, in the production configuration traversal action's traversal sequence;
add an instance creation operator action, shortly referred to as purchase instance creation action, in the business configuration root action; add a traversal action, shortly referred to as purchase configuration traversal action, in the business configuration root action;
add an increment action, shortly referred to as purchase serial number increment action, in the purchase configuration traversal action's traversal sequence; add an assignment action, shortly referred to as purchase serial number assignment action, in the purchase configuration traversal action's traversal sequence;
add an assignment operator action, shortly referred to as sales serial number reset assignment operator, in the business configuration root action; add an instance creation operator action, shortly referred to as sales instance creation action in the business configuration root action; add a traversal action, shortly referred to as sales configuration traversal action, in the business configuration root action;
add an increment action, shortly referred to as sales serial number increment action, in the sales configuration traversal action's traversal sequence; add an assignment action, shortly referred to as sales serial number assignment action, in the sales configuration traversal action's traversal sequence; add a traversal action, shortly referred to as sales-production configuration traversal action, in the sales configuration traversal action's traversal sequence;
add a consistency comparison action, shortly referred to as sales-production configuration comparison action, in the sales-production configuration traversal action's traversal sequence, wherein the consistency comparison action is an operator action with a prefabricated function for comparing whether or not two inputs are consistent; add a condition action shortly referred to as sales-production configuration condition action, in the sales-production configuration traversal action's traversal sequence, wherein the condition action is a logic action with a prefabricated condition selection function;
add an assignment action, shortly referred to as sales-production assignment action, in the "true" branch of the sales-production configuration condition action;
add an increment traversal action, shortly referred to as sales-purchase configuration traversal action, in the sales configuration traversal action's traversal sequence;
add a consistency comparison action, shortly referred to as sales-purchase configuration comparison action, in the sales-purchase configuration traversal action's traversal sequence; add a condition action, shortly referred to as a sales-purchase configuration condition action, in the sales-purchase configuration traversal action's traversal sequence; and
add an assignment action, shortly referred to as sales-purchase assignment action in the "true" branch of the sales-purchase configuration condition action.

### Business operation process model

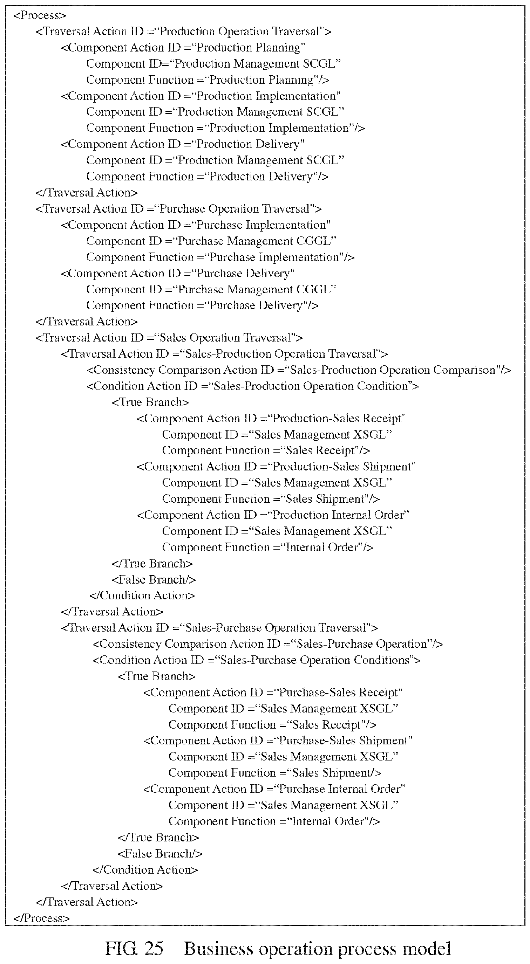

Fig. 25 shows a completed business operation process model for the business management YWGL component class, whose construction process is similar to that of the "main business procedure process model" and the content thereof is as follows:
add a traversal action, shortly referred to as production operation traversal action, in the business operation root action;
add an action based on the production management SCGL component class' production planning function, shortly referred to as production planning action, in the production operation traversal action's traversal sequence; add an action based on the production management SCGL component class' production implementation function, shortly referred to as production implementation action, in the production operation traversal action's traversal sequence; add an action based on production management SCGL component class' production delivery function, shortly referred to as production delivery action, in the production operation traversal action's traversal sequence;
add a traversal action, shortly referred to as purchase operation traversal action, in the business operation root action;
add an action based on the purchase management CGGL component class' purchase implementation function, shortly referred to as purchase implementation action, in the purchase operation traversal action's traversal sequence; add an action based on the purchase management CGGL component class' purchase delivery function, shortly referred to as purchase delivery action, in the purchase operation traversal action's traversal sequence;
add a traversal action, shortly referred to as sales operation traversal action, in the business operation root action;
add a traversal action, shortly referred to as sales-production operation traversal action, in the sales operation traversal action's traversal sequence;
add a consistency comparison action, shortly referred to as sales-production operation comparison action, in the sales-production operation traversal action's traversal sequence; add a condition action, shortly referred to as sales-production operation condition action, in the sales-production operation traversal action's traversal sequence; and
add an action based on the sales management XSGL component class' sales receipt function, shortly referred to as a production-sales receipt action, in the "true" branch of the sales-production operation condition action; add an action based on the sales management XSGL component class' sales shipment function, shortly referred to as production-sales shipment action, in the "true" branch of the sales-production operation condition action; add an action based on the sales management XSGL component class' sales internal order function, shortly referred to as production-sales internal order action, in the "true" branch of the sales-production operation condition action;
add a traversal action, shortly referred to as sales-purchase operation traversal action, in the sales operation traversal action's traversal sequence;
add a consistency comparison action, shortly referred to as sales-purchase operation comparison action, in the sales-purchase operation traversal action's traversal sequence; add a condition action shortly referred to as sales-purchase operation condition action, in the sales operation traversal action's traversal sequence;
add an action based on the sales management XSGL component class' sales receipt function, shortly referred to as purchase-sales receipt action, in the "true" branch of the sales-purchase operation condition action; add an action based on the sales management XSGL component class' sales shipment function, shortly referred to as purchase-sales shipment action, in the "true" branch of the sales-purchase operation condition action; add an action based on the sales management XSGL component class' sales internal order function, shortly referred to as purchase-sales internal order action, in the "true" branch of the sales-purchase operation condition action.

### Internal order process model

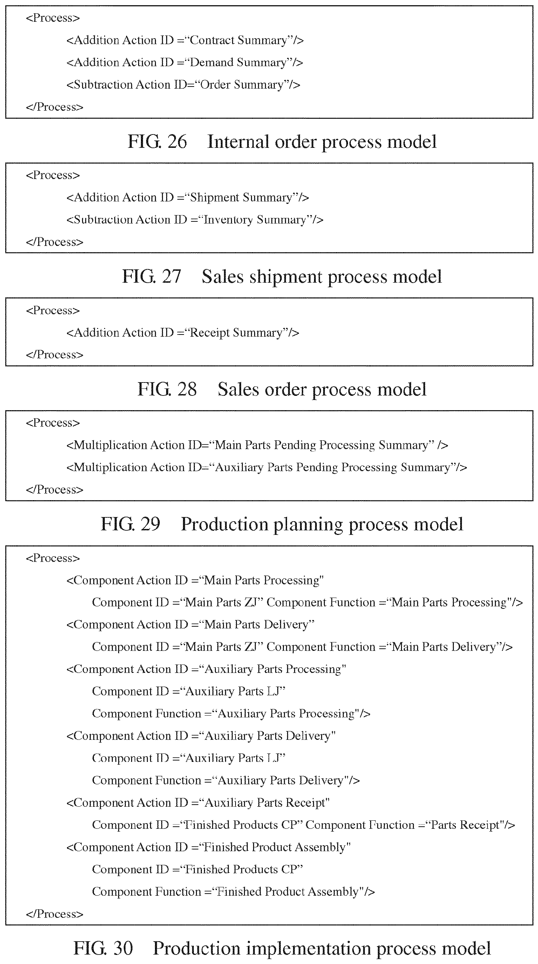

Fig. 26 shows a completed internal order process model for the sales management XSGL component class whose construction process is similar to that of "main business procedure process model" and the content thereof is as follows:
add an addition action, shortly referred to as contract summary action, in the internal order root action, wherein the addition action is an operator action with an addition function; add an addition action, shortly referred to as a demand summary action, in the internal order root action; add a subtraction action, shortly referred to as order summary action, in the internal order root action, wherein the subtraction action is an operator action with subtraction function.

### Sales shipment process model

Fig. 27 shows a completed sales shipment process model for the sales management XSGL component class, whose construction process is similar to that of "main business procedure process model" and the content thereof is as follows:
add an addition action, shortly referred to as shipment summary action, in the sales shipment root action; add a subtraction action, shortly referred to as inventory summary action, in the sales shipment root action, wherein the subtraction action is an operator action with subtraction function.

### Sales order process model

Fig. 28 shows a completed sales order process model for the sales management XSGL component class whose construction process is similar to that of the "main business procedure process model" and the content thereof is as follows:
add an addition action, shortly referred to as receipt summary action, in the sales receipt root action.

### Production planning process model

Fig. 29 shows a completed production planning process model for the production management SCGL component class, whose construction process is similar to that of the "main business procedure process model and the content thereof is as follows:
add a multiplication action, shortly referred to as main parts pending processing summary action, in the production planning root action, wherein the multiplication action is an operator action with multiplication function; add another multiplication action, shortly referred to as auxiliary parts pending processing summary action in the production planning root action.

### Production implementation process model

Fig. 30 shows a completed production implementation process model for the production management SCGL component class, whose construction process is similar to that of the "main business procedure process model" and the content thereof is as follows:
add an action based on main parts ZJ component class' main parts processing function, referred to as a main parts processing action, in the production implementation root action; add an action based on main parts ZJ component class' main parts delivery function, referred to as main parts delivery action, in the production implementation root action; add an action based on auxiliary parts LJ component class' auxiliary parts processing function, referred to as auxiliary parts processing action, in the production implementation root action; add an action based on auxiliary parts LJ component class' auxiliary parts delivery function, referred to as auxiliary parts delivery action, in the production implementation root action; an action based on finished products CP component class' parts receipt function, referred to as parts receipt action, in the production implementation root action; add an action based on finished products CP component class' a finished product assembly function, referred to as finished product assembly action, in the production implementation root action.

### Production delivery process model

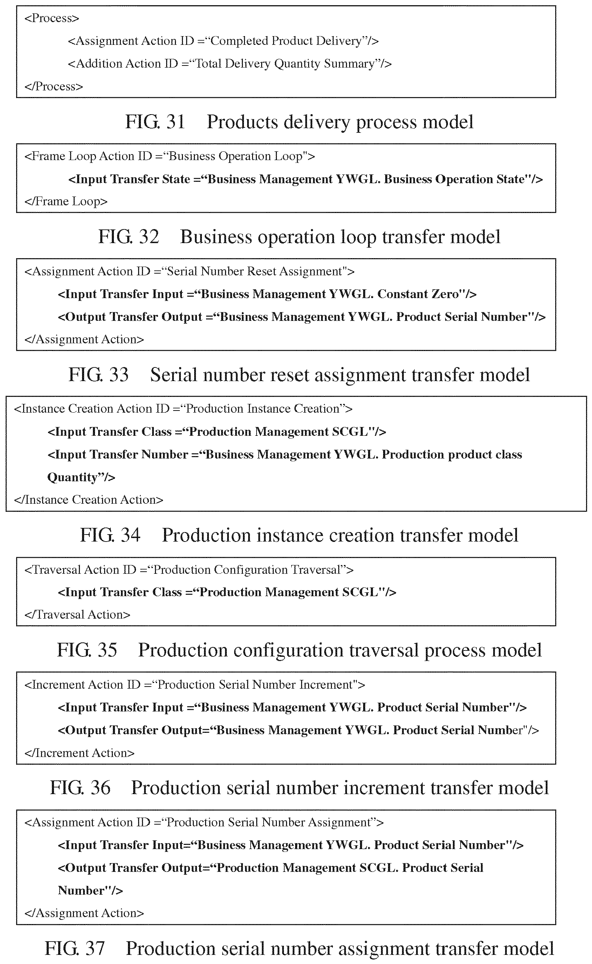

Fig. 31 shows a completed production delivery process model for the production management SCGL component class, whose construction process is similar to that of the "main business procedure process model" and the content thereof is as follows:
add an assignment action, shortly referred to as a completed product delivery action, in the production delivery root action; add an addition action, shortly referred to as total delivery quantity summary action, in the production delivery root action.

So far, all process models of this embodiment are accomplished.

### Constructing the transfer models

Next, the construction process of the transfer model for each action will be described in detail.

### Business configuration transfer model

### (null)

### Business operation loop transfer model

Fig. 32 shows a completed business operation loop transfer model whose construction process is as follows:
the hierarchy mold receives and responds to command from the actual system modeling environment to set the business management YWGL component class as the involved component class;
the interface mold receives and responds to command from the actual system modeling environment to set the main business procedure function as the involved function;
the process mold receives command from the actual system modeling environment to set the business operation loop action as the involved action; the transfer mold constructs a transfer model for the involved action, yielding the transfer model for business operation loop action; for simplicity, the transfer model for business operation loop action is shortly referred to as business operation loop transfer model in accordance with name of the action; names of other transfer models may be deduced by analogy, which will not be repeated; and
the transfer mold receives and responds to command from the actual system modeling environment to establish a transfer from the business management YWGL component class' business operation state attribute to the business operation loop action's state attribute, wherein the business operation loop action's state attribute, as a Boolean variable, refers to an abbreviation of a state attribute for the business loop operation action to control whether or not operates; and names of the subsequent action's attributes may be deduced by analogy, which will not be repeated.

So far, the business operation loop transfer model is accomplished.

### Business operation transfer model

(null)

### Serial number reset assignment transfer model

Fig. 33 shows a completed serial number reset assignment transfer model whose construction process is similar to that of "business operation loop transfer model" and the content thereof contains the following transfers:
from the business management YWGL component class' constant zero attribute to the sales serial number reset assignment action's input attribute; and from sales serial number reset assignment action's output attribute to the business management YWGL component class' product serial number attribute.

### Production instance creation transfer model

Fig. 34 shows a completed production instance creation transfer model whose construction process is similar to that of the "business operation loop transfer model" and the content thereof contains the following transfers:
from the production management SCGL component class' name attribute to production instance creation action's type attribute; and from the produced quantity attribute of business management YWGL component class' product type attribute to the quantity attribute of production instance creation action.

### Production configuration traversal transfer model

Fig. 35 shows a completed production configuration traversal transfer model whose construction process is similar to that of the "business operation loop transfer model" and the content thereof contains the following transfers:
from the production management SCGL component class' name attribute to the production configuration traversal action's type attribute.

### Production serial number increment transfer model

Fig. 36 shows a completed production serial number increment transfer model whose construction process is similar to that of the "business operation loop transfer model" and the content thereof contains the following transfers:
from the business management YWGL component class' product serial number attribute to production serial number increment action's input attribute; and from production serial number increment action's output attribute to business management YWGL component class' product serial number attribute.

### Production serial number assignment transfer model

Fig. 37 shows a completed production serial number assignment transfer model whose construction process is similar to that of the "business operation loop transfer model" and the content thereof contains the following transfers:
from business management YWGL component class' product serial number attribute to production serial number assignment action's input attribute; and from production serial number assignment action's output attribute to production management SCGL component class' product serial number attribute.

### Purchase instance creation transfer model

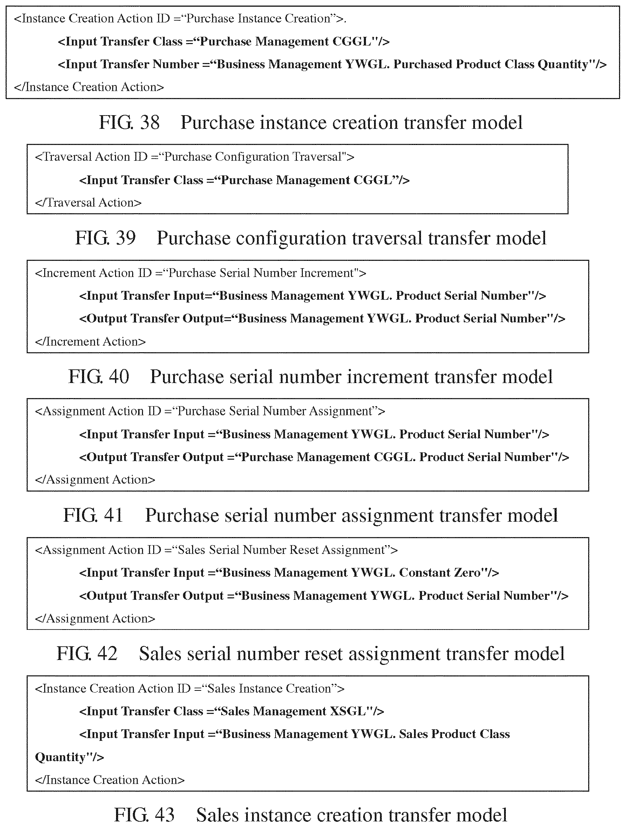

Fig. 38 shows a completed purchase instance creation transfer model whose construction process is similar to that of the "business operation loop transfer model" and the content thereof contains the following transfers:
from the purchase management CGGL component class' name attribute to purchase instance creation action's type attribute; and from purchased product type quantity attribute of business management YWGL component class to purchase instance creation action's instance quantity attribute.

### Purchase configuration traversal transfer model

Fig. 39 shows a completed purchase configuration traversal transfer model whose construction process is similar to that of the "business operation loop transfer model" and the content thereof contains the following transfers:
from purchase management CGGL component class' name attribute to purchase configuration traversal action's type attribute.

### Purchase serial number increment transfer model

Fig. 40 shows a completed purchase serial number increment transfer model whose construction process is similar to that for the "business operation loop transfer model" and the content thereof contains the following transfers:
from the business management YWGL component class' product serial number attribute to purchase serial number increment action's input attribute; and from purchase serial number increment action's output attribute to business management YWGL component class' product serial number attribute.

### Purchase serial number assignment transfer model

Fig. 41 shows a completed purchase serial number assignment transfer model whose construction process is similar to that of the "business operation loop transfer model" and the content thereof contains the following transfers:
from the business management YWGL component class' product serial number attribute to purchase serial number assignment action's input attribute; and from purchase serial number assignment action's output attribute to purchase management CGGL component class' product serial number attribute.

### Sales serial number reset assignment transfer model

Fig. 42 shows a completed sales serial number reset assignment transfer model whose construction process is similar to that of the "business operation loop transfer model" and the content thereof contains the following transfers:
from the business management YWGL component class' constant zero attribute to the sales serial number reset assignment action's input attribute; and from the sales serial number reset assignment action's output attribute to business management YWGL component class' product serial number attribute.

### Sales instance creation transfer model

Fig. 43 shows a completed sales instance creation transfer model whose construction process is similar to that of the "business operation loop transfer model" and the content thereof contains the following transfers:
from the sales management CGGL component class' name attribute to sales instance creation action's type attribute; and from business management YWGL component class' sales product type quantity attribute to sales instance creation action's quantity attribute.

### Sales configuration transfer model

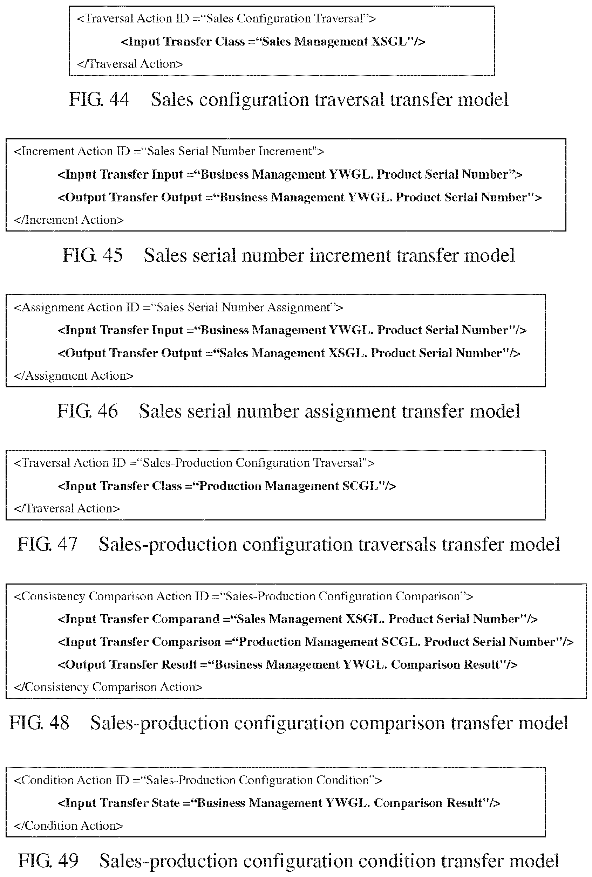

Fig. 44 shows a completed sales configuration transfer model whose construction process is similar to that of the "business operation loop transfer model" and the content thereof contains the following transfers:
from the sales management XSGL component class' name attribute to sales configuration traversal action's type attribute.

### Sales serial number increment transfer model

Fig. 45 shows a completed sales serial number increment transfer model whose construction process is similar to that of the "business operation loop transfer model" and the content thereof contains the following transfers:
from the business management YWGL component class' product serial number attribute to sales serial number increment action's input attribute; and from sales serial number increment action's output attribute to business management YWGL component class' product serial number attribute.

### Sales serial number assignment transfer model

Fig. 46 shows a completed sales serial number assignment transfer model whose construction process is similar to that of the "business operation loop transfer model" and the content thereof contains the following transfers:
from the business management YWGL component class' product serial number attribute to sales serial number assignment action's input attribute; and from sales serial number assignment action's output attribute to sales management XSGL component class' product serial number attribute.

### Sales-production configuration traversal transfer model

Fig. 47 shows a completed sales-production configuration traversal transfer model whose construction process is similar to that of the "business operation loop transfer model" and the content thereof contains the following transfers:
from the production management SCGL component class' name attribute to sales-production configuration traversal action's type attribute.

### Sales-production configuration comparison transfer model

Fig. 48 shows a completed sales-production configuration comparison transfer model whose construction process is similar to that of the "business operation loop transfer model" and the content thereof contains the following transfers:
from the sales management XSGL component class' product serial number attribute to sales-production configuration comparison action's comparison attribute; from the production management SCGL component class' product serial number attribute to sales-production configuration comparison action's comparison attribute; and from the sales-production configuration comparison action's result attribute to the business management YWGL component class' comparison result attribute.

### Sales-production configuration condition transfer model

Fig. 49 shows a completed sales-production configuration condition transfer model whose construction process is similar to that of the "business operation loop transfer model" and the content thereof contains the following transfers:
from the business management YWGL component class' comparison result attribute to sales-production configuration condition action's state attribute.

### Sales-production assignment transfer model

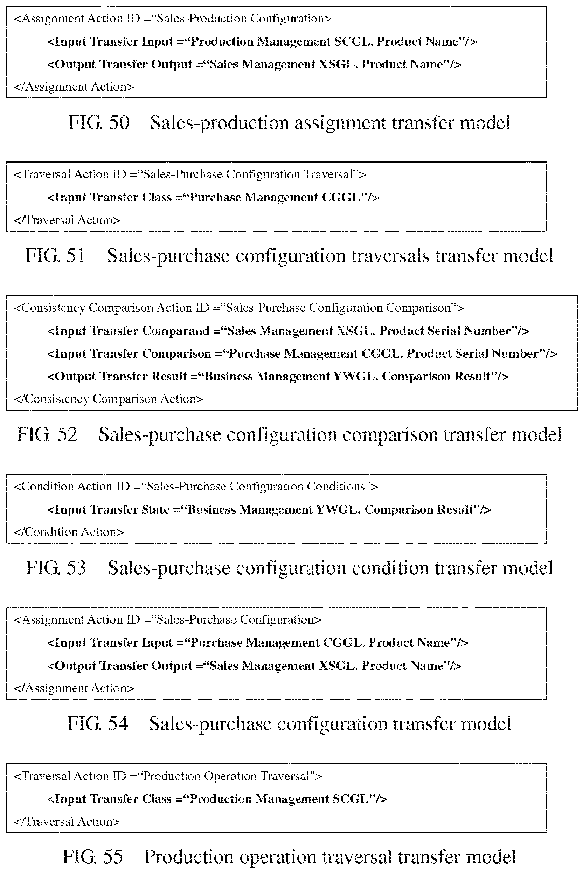

Fig. 50 shows a completed sales-production assignment transfer model whose construction process is similar to that of the "business operation loop transfer model" and the content thereof contains the following transfers:
from the production management SCGL component class' product name attribute to sales-production assignment action's input attribute; and sales-production assignment action's output attribute to sales management XSGL component class' product name attribute.

### Sales-purchase configuration traversal transfer model

Fig. 51 shows a completed sales-purchase configuration traversal transfer model whose construction process is similar to that of the "business operation loop transfer model" and the content thereof contains the following transfers:
from the purchase management CGGL component class' name attribute to sales-purchase configuration traversal action's type attribute.

### Sales-purchase configuration comparison transfer model

Fig. 52 shows a completed sales-purchase configuration comparison transfer model whose construction process is similar to that of the "business operation loop transfer model" and the content thereof contains the following transfers:
from the sales management XSGL component class' product serial number attribute to the sales-purchase configuration comparison action's comparison attribute; from the purchase management CGGL component class' product serial number attribute to sales-purchase configuration comparison action's comparison attribute; and from the sales-purchase configuration comparison action's result attribute to business management YWGL component class' comparison result attribute.

### Sales-purchase configuration condition transfer model

Fig. 53 shows a completed sales-purchase configuration condition transfer model whose construction process is similar to that of the "business operation loop transfer model" and the content thereof contains the following transfers:
from the business management YWGL component class' comparison result attribute to the sales-purchase configuration condition action's state attribute.

### Sales-purchase configuration transfer model

Fig. 54 shows a completed sales-purchase configuration transfer model whose construction process is similar to that of the "business operation loop transfer model" and the content thereof contains the following transfers:
from the purchase management CGGL component class' product name attribute to sales-purchase assignment action's input attribute; and from sales-purchase assignment action's output attribute to sales management XSGL component class' product name attribute.

### Production operation traversal transfer model

Fig. 55 shows a completed production operation traversal transfer model whose construction process is similar to that of the "business operation loop transfer model" and the content thereof contains the following transfers:
from the production management SCGL component class' name attribute to production operation traversal action's type attribute.

### Production planning transfer model

(null)

### Production implementation transfer model

(null)

### Production delivery transfer model

(null)

### Purchase operation traversal transfer model

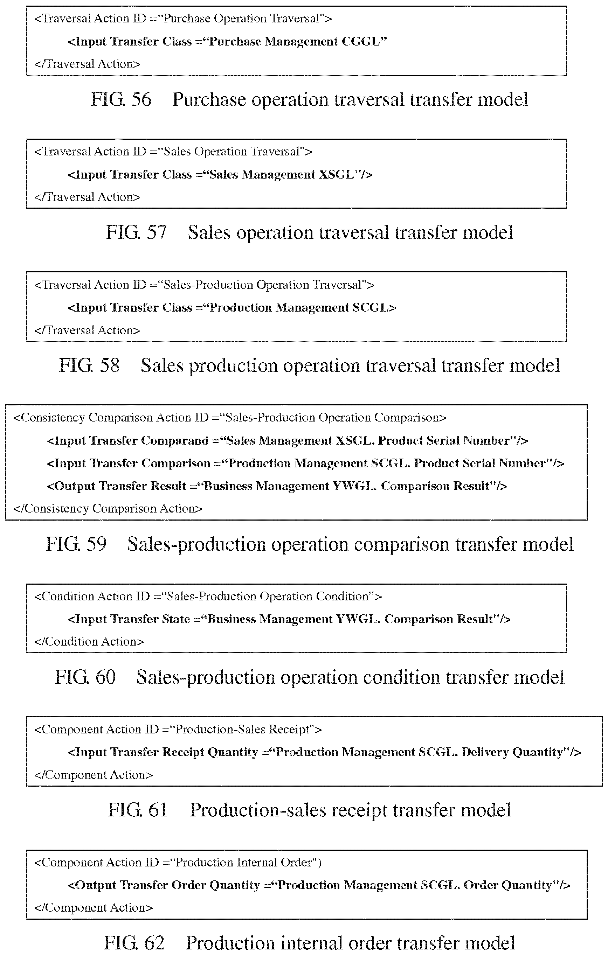

Fig. 56 shows a completed purchase operation traversal transfer model whose construction process is similar to that of the "business operation loop transfer model" and the content thereof contains the following transfers:
from the purchase management CGGL component class' name attribute to purchase operation traversal action's type attribute.

### Purchase implementation transfer model

(null)

### Purchase delivery transfer model

(null)

### Sales operation traversal transfer model

Fig. 57 shows a completed sales operation traversal transfer model whose construction process is similar to that of the "business operation loop transfer model" and the content thereof contains the following transfers:
from the sales management XSGL component class' name attribute to sales operation traversal action's type attribute.

### Sales-production operation traversal transfer model

Fig. 58 shows a completed sales-production operation traversal transfer model whose construction process is similar to that of the "business operation loop transfer model" and the content thereof contains the following transfers:
from the production management SCGL component class' name attribute to sales-production operation traversal action's type attribute.

### Sales-production operation comparison transfer model

Fig. 59 shows a completed sales-production comparison operation transfer model whose construction process is similar to that of the "business operation loop transfer model" and the content thereof contains the following transfers:
from the sales management XSGL component class' product serial number attribute to sales-production operation comparison action's comparison attribute; from production management SCGL component class' product serial number attribute to sales-production operation comparison action's comparison attribute; and sales-production operation comparison action's result attribute to business management YWGL component class' comparison result attribute.

### Sales-production operation condition transfer model

Fig. 60 shows a completed sales-production operation condition transfer model whose construction process is similar to that of the "business operation loop transfer model" and the content thereof contains the following transfers:
from the business management YWGL component class' comparison result attribute to the sales-production operation condition action's state attribute.

### Production-sales receipt transfer model

Fig. 61 shows a completed production-sales receipt transfer model whose construction process is similar to that of the "business operation loop transfer model" and the content thereof contains the following transfers:
from the production management SCGL component class' delivery quantity attribute to production-sales receipt action's receipt quantity attribute.

### Production-sales shipment transfer model

(null)

### Production internal order transfer model

Fig. 62 shows a completed production internal order transfer model whose construction process is similar to that of the "business operation loop transfer model" and the content thereof contains the following transfers:
from the production internal order action's order quantity attribute to production management SCGL component class' order quantity attribute.

### Sales-purchase operation traversal transfer model

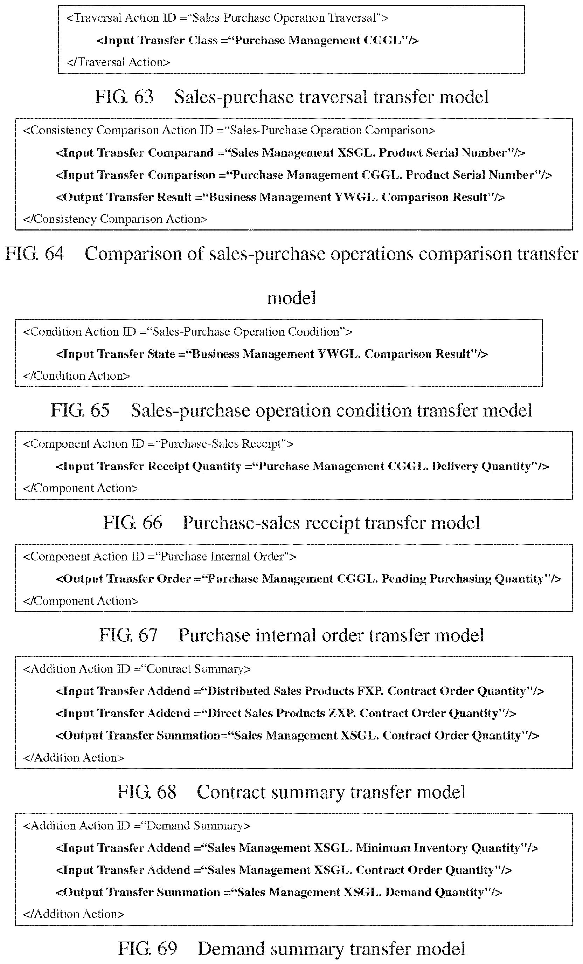

Fig. 63 shows a completed sales-purchase operation traversal transfer model whose construction process is similar to that of the "business operation loop transfer model" and the content thereof contains the following transfers:
from the purchase management CGGL component class' name attribute to the sales-purchase operation traversal action's type attribute.

### Sales-purchase operation comparison transfer model

Fig. 64 shows a completed the sales-purchase operation comparison transfer model whose construction process is similar to that of the "business operation loop transfer model" and the content thereof contains the following transfers:
from the sales management XSGL component class' product serial number attribute to sales-purchase operation comparison action's comparison attribute; from the purchase management CGGL component class' product serial number attribute to sales-purchase operation comparison action's comparison attribute; and from the sales-purchase operation comparison action's result attribute to the business management YWGL component class' comparison result attribute.

### Sales-purchase operation condition transfer model

Fig. 65 shows a completed sales-purchase operation condition transfer model whose construction process is similar to that of the "business operation loop transfer model" and the content thereof contains the following transfers:
from the business management YWGL component class' comparison result attribute to the sales-purchase operation condition action's state attribute.

### Purchase-sales receipt transfer model

Fig. 66 shows a completed purchase-sales receipt transfer model whose construction process is similar to that of the "business operation loop transfer model" and the content thereof contains the following transfers:
from the purchase management CGGL component class' delivery quantity attribute to the purchase-sales receipt action's receipt quantity attribute.

### Purchase-sales shipment transfer model

(null)

### Purchase internal order transfer model

Fig. 67 shows a completed purchase internal order transfer model whose construction process is similar to that of the "business operation loop transfer model" and the content thereof contains the following transfers:
from purchase internal order action's order quantity attribute to purchase management CGGL component class' pending purchasing quantity attribute.

### Contract summary transfer model

Fig. 68 shows a completed contract summary transfer model whose construction process is similar to that of the "business operation loop transfer model" and the content thereof contains the following transfers:
from the distributed sales products FXP component class' contract order quantity attribute to the contract summary action's augend attribute; from the direct sales products ZXP component class' contract order quantity attribute to the contract summary action' addend attribute; and from the contract summary action's sum attribute to the sales management XSGL component class' contract order quantity attribute.

### Demand summary transfer model

Fig. 69 shows a completed demand summary transfer model whose construction process is similar to that of the "business operation loop transfer model" and the content thereof contains the following transfers:
from the sales management XSGL component class' minimum inventory attribute to an augend attribute of the demand summary action; from the sales management XSGL component class' contract order quantity attribute to the demand summary action's addend attribute; and from the demand summary action's sum attribute to the sales management XSGL component class' demand quantity attribute.

### Order summary transfer model

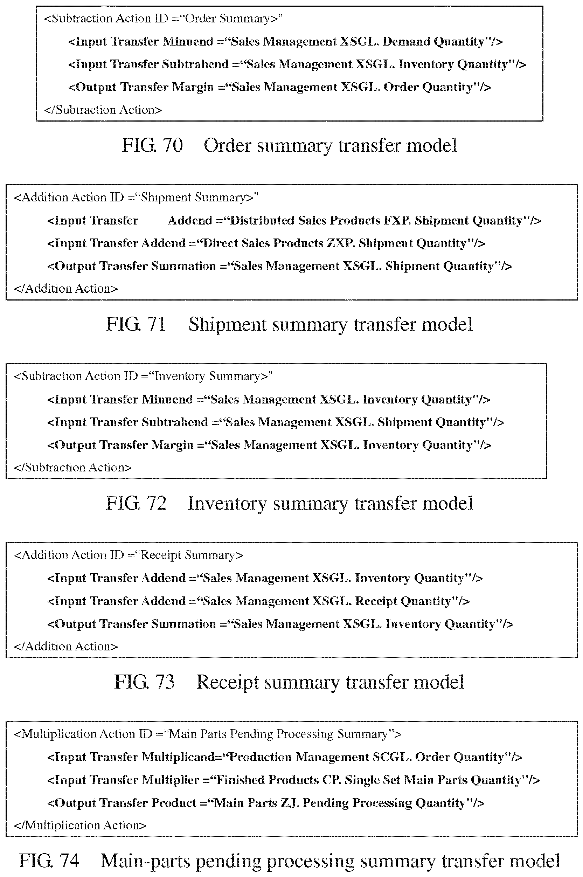

Fig. 70 shows a completed order summary transfer model whose construction process is similar to that of the "business operation loop transfer model" and the content thereof contains the following transfers:
from the sales management XSGL component class' demand quantity attribute the order summary action's minuend attribute; from the sales management XSGL component class' inventory quantity attribute to order summary action's subtrahend attribute; and from order summary action's margin attribute to the sales management XSGL component class' order quantity attribute.

### Shipment summary transfer model

Fig. 71 shows a completed shipment summary transfer model whose construction process is similar to that of the "business operation loop transfer model" and the content thereof contains the following transfers:
from the distributed products FXP component class' shipment quantity attribute to shipment summary action's augend attribute; from the direct sales products ZXP component class' shipment quantity attribute to shipment summary action's addend attribute; and from shipment summary action's sum attribute to the sales management XSGL component class' shipment quantity attribute.

### Inventory summary transfer model

Fig. 72 shows a completed inventory summary transfer model whose construction process is similar to that of the "business operation loop transfer model" and the content thereof contains the following transfers:
from the sales management XSGL component class' inventory quantity attribute to inventory summary action's minuend attribute; from the sales management XSGL component class' shipment quantity attribute to inventory summary action's subtrahend attribute; and from the inventory summary action's margin attribute to the sales management XSGL component class' inventory quantity attribute.

### Receipt summary transfer model

Fig. 73 shows a completed receipt summary transfer model whose construction process is similar to that of the "business operation loop transfer model" and the content thereof contains the following transfers:
from the sales management XSGL component class' inventory quantity attribute to receipt summary action's augend attribute; from the sales management XSGL component class' receipt quantity attribute to receipt summary action's addend attribute; and from receipt summary action's sum attribute to the sales management XSGL component class' inventory quantity attribute.

### Main parts pending processing summary transfer model

Fig. 74 shows a completed main parts pending processing summary transfer model whose construction process is similar to that of the "business operation loop transfer model" and the content thereof contains the following transfers:
from the production management SCGL component class' order quantity attribute to the main parts pending processing summary action's multiplicand attribute; from the finished products CP component class' single set main parts quantity attribute to main parts pending processing summary action's multiplier attribute; and from main parts pending processing summary action's product attribute to the main parts ZJ component class' pending processing quantity attribute.

### Auxiliary parts pending processing summary transfer model

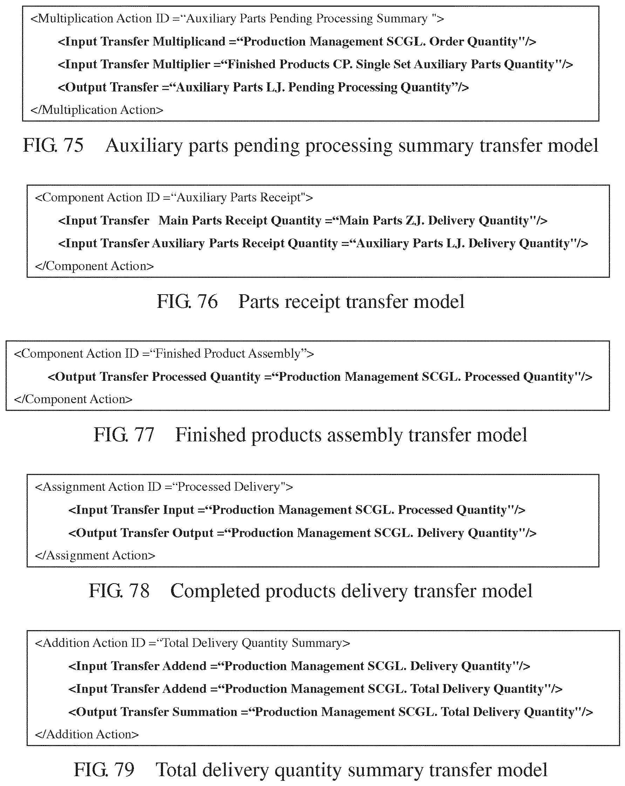

Fig. 75 shows a completed auxiliary parts pending processing summary transfer model whose construction process is similar to that of the "business operation loop transfer model" and the content thereof contains the following transfers:
from the production management SCGL component class' order quantity attribute to auxiliary parts pending processing summary action's multiplicand attribute; from the finished products CP component class' single set auxiliary parts quantity attribute to auxiliary parts pending processing summary action's multiplier attribute; and from auxiliary parts pending processing summary action's product attribute to the main parts ZJ component class' pending processing quantity attribute.

### Main parts processing transfer model

(null)

### Main parts delivery transfer model

(null)

### Auxiliary parts processing transfer model

(null)

### Auxiliary parts delivery transfer model

(null)

### Parts receipt transfer model

Fig. 76 shows a completed parts receipt transfer model whose construction process is similar to that of the "business operation loop transfer model" and the content thereof contains the following transfers:
from delivery quantity attribute of the main parts ZJ component class to the main parts receipt action's receipt attribute; and from the auxiliary parts LJ component class' delivery quantity attribute to the auxiliary parts receipt action's receipt attribute.

### Finished product assembly transfer model

Fig. 77 shows a completed finished product assembly transfer model whose construction process is similar to that of the "business operation loop transfer model" and the content thereof contains the following transfers:
from finished product assembly action's processed quantity attribute to the production management SCGL component class' processed quantity attribute.

### Processed delivery transfer model

Fig. 78 shows a completed processed delivery transfer model whose construction process is similar to that of the "business operation loop transfer model" and the content thereof contains the following transfers:
from the production management SCGL component class' processed quantity attribute to processed delivery action's input attribute; and from the processed delivery action's output attribute to production management SCGL component class' processed delivery quantity attribute.

### Total delivery quantity summary transfer model

Fig. 79 shows a completed total delivery quantity summary transfer model whose construction process is similar to that of the "business operation loop transfer model" and the content thereof contains the following transfers:
from the production management SCGL component class' total delivery quantity attribute to total delivery quantity summary action's augend attribute; from production management SCGL component class' a total delivery quantity attribute to the total delivery quantity summary action's addend attribute; and from total delivery quantity summary action's sum attribute to the production management SCGL component class' total delivery quantity.

The business management YWGL system model constituted by a hierarchy model, interface models, algorithm models, process models, and transfer models in this embodiment has been accomplished.

This embodiment demonstrates how a regular management personnel, without knowledge of any existing complex system modeling languages, without knowledge of any computer programming language, and without dependence on any professional modeler nor any application developer, by using the present invention, independently constructs an executable business management system model based on his vision in business management within a relatively short period of time. The constructed system model is not only clear and simple but also the quality of the constructed system model is significantly higher and the time spent is significantly shorter.

Compared with developing a business management system model with the cooperation of professional modelers and/or application developers, the present invention by which the same manager independently develops the business management system model, achieves remarkable results as follows:
(1) higher quality: the completed system model meets the minds of the managers and avoids the possible bias in understanding of the business management system model between the managers and professional modelers or application developers;
(2) shorter time spent: the entire period of time spent to model is shortened to 1/5 of the original time period because the complex and frequent communications between the managers and the professional modelers or the application developers are eliminated, thereby greatly saving energy and money.

## Claims

1. A method for general modeling basing on system meta-model to construct system model by means of a computer readable storage medium having a computer readable program code stored therein, said computer readable program code containing instructions executable by a processor of a computer system to implement a method of constructing system model by processing data conforming to the system meta-model, said system meta-model comprising:
a hierarchy mold which describes the hierarchy model of the system model in a tree structure of which a node is a component class and which is used as a template to be configured in an actual system modeling environment to form the hierarchy model of the system model, wherein the hierarchy model refers to the hierarchy relationships constituted by the component classes as the nodes in the system model, wherein the component class refers to a set of component instances with the same external features, and wherein the tree structure, of which the nodes are component classes, in the system model is referred as a hierarchy tree;
an interface mold which describes interface models by an optional structure of an attribute set, a function set, and an event set; the interface mold is used as a template in the actual system modeling environment to be configured to form interface models, wherein interface models refers to external features of component classes, wherein the functions in the function set include both algorithm functions and process functions, wherein an algorithm functions is implemented by an algorithm model, and wherein a process function is implemented by a combination of a process model and transfer models;
an algorithm mold which describes algorithm models by a tree structure of which nodes are operators and which is used as a template in actual system modeling environment to be configured to form the algorithm model, wherein the algorithm model refers to a description of the algorithm which implements a function by using the combination of operators, and wherein operator refers to component with a previously realized specific function;
a process mold which describes process models by combining actions as nodes, and as a template, to configure process models in the actual system modeling environment, wherein the process model refers to a description of a way of a function which is implemented using a combination of the actions and wherein the action refers to an execution of a function;
a transfer mold which describes transfer models by a transfer set and which is used as a template in actual system configuration modeling environment to be configured to form transfer models, wherein transfer model refers to transfer relationships of the data of involved actions and a transfer in the transfer set is transfer relationship of the data between one attribute and another attribute;
specific steps to construct the system model described by the said five molds being as follows:
1) constructing the hierarchy model: the hierarchy mold reads in hierarchy model commands from the actual system modeling environment, wherein hierarchy model commands refers to commands such as creating a component class, adding a component class, selecting a component class, naming a component class, and deleting a component class for the hierarchy tree and wherein the hierarchy mold performs corresponding operations on the component class nodes in response to hierarchy model commands to obtain the hierarchy model;
2) constructing the interface models: construct an interface model for each component class of the hierarchy model obtained in the step 1), the steps for constructing each interface model including: the interface mold reads in of interface model commands from the actual system modeling environment, wherein interface model commands refers to commands such as creating, naming, and deleting the attributes, the functions, and the events, wherein the interface mold performs corresponding operations in response to interface model commands to obtain the interface model, and wherein the algorithm models for implementing algorithm functions are constructed by step 3) and process models for implementing process functions are constructed by the step 4);
3) constructing the algorithm models: constructing an algorithm model for each algorithm function obtained in the step 2), the steps for constructing each algorithm model including: the algorithm mold reads in algorithm model commands from the actual system modeling environment;
4) constructing the process models: constructing a process model for each process function obtained in the step 2), the steps for constructing each process model including: the process mold reads in process model command from the actual system modeling environment; and
5) constructing the transfer models: constructing a transfer model for each action in the process model obtained in the step 4), the steps for constructing each transfer model including: the transfer mold reads in transfer model commands from the actual system modeling environment, wherein transfer model commands refers to commands on such as adding a transfer, adding a transfer, and deleting a transfer and wherein the transfer mold performs corresponding operations in response to transfer model commands to obtain the transfer model,
thereby the system model constructed by a hierarchy model, interface models, algorithm models, process models, and transfer models is accomplished.

2. The method for general modeling basing on system meta model to construct system model in claim 1, wherein a combination of the process mold and the transfer mold provide a universal means to describe and configure functions; the algorithm mold provides a simplified alternative for replacing the combination of the process mold and the transfer mold if only operators are used to implement the functions.

3. The method for general modeling basing on system meta model to construct system model in claim 1, wherein the system meta model has the following modeling rules: the system meta model employs a parent-child structure as base recursive unit to recursively describe the system model; the parent-child structure refers to a structure of parent-child relationships in a hierarchy tree, constituted by node of involved component class and all nodes of child component classes thereof.

4. The method for general modeling basing on system meta model to construct system model in claim 1, wherein the specific function of the step 2) can only be either algorithm function or process function, not both.

5. The method for general modeling basing on system meta model to construct system model in claim 1, wherein algorithm model commands stated in the step 3) refers to commands, such as adding an operator, selecting an operator, naming an operator, as well as adding an assignment, selecting an assignment, and deleting an assignment, and the algorithm mold performs corresponding operations in response to the algorithm model commands to obtain the algorithm model; the operators include logic operators with logic functions and computation operators with calculation functions; a tree structure which nodes are operators is referred to as an algorithm tree; the said assignment refers to an assignment relationship between two attributes in a set of the algorithm attributes, and the set of the algorithm attributes refers to a collection constituted by an attribute set of the involved component classes and an attribute set of all of operators in the algorithm model.

6. The method for general modeling basing on system meta model to construct system model in claim 1, wherein process model commands to construct the process model in step 4) refers to commands such as adding an action, selecting an action, naming an action, and deleting an action and the process mold performs a corresponding operation in response to the process model commands to obtain the process model; the actions include both component actions and operator actions; said component action refers to one execution of the functions in the function set in the parent-child structure, the function set in the parent-child structure refers to a collection constituted by the function set of the involved component class and function sets of all child component classes in the parent-child structure; operator actions refers to one execution of operator's function; process models include both an attribute process model and an event process model, the process mold includes both attribute process molds and event process molds, attribute process mold describes the attribute process model through a process tree as the structure, which is a tree structure constituted by actions as nodes; an event process mold describes an event process model by a set of event associations as the structure; an event association in the set of event associations is an association relationship between an event in an event set in a parent-child structure and an operator action or a component action; the event set in the parent-child structure is the event set of the involved component class and event sets of all of child component classes in the parent-child structure.

7. The method for general modeling basing on system meta model to construct system model in claim 1, wherein besides action attributes which refers to the attribute of the component class where the action is, said attributes relevant to transfers are limited to the parent-child attribute set, which refers to a collection constituted by the attribute set of the involved component classes and attribute sets of all of child component classes in the parent-child structure.
